Europäisches Patentamt

European Patent Office

Office européen des brevets

(11) Veröffentlichungsnummer: **0 025 426**

**A1**

(12) # EUROPÄISCHE PATENTANMELDUNG

(21) Anmeldenummer: **80890093.0**

(51) Int. Cl.³: **H 05 K 9/00**

(22) Anmeldetag: **29.08.80**

(30) Priorität: **07.09.79 AT 5905/79**

(43) Veröffentlichungstag der Anmeldung:
**18.03.81 Patentblatt 81/11**

(84) Benannte Vertragsstaaten:
**CH DE GB LI NL**

(71) Anmelder: **SIEMENS AKTIENGESELLSCHAFT
ÖSTERREICH
Apostelgasse 12
A-1030 Wien(AT)**

(72) Erfinder: **Pohl, Ulrich
Eisteichstrasse 10
A-1110 Wien(AT)**

(74) Vertreter: **Pater, Max, Dr.
Apostelgasse 12
A-1030 Wien(AT)**

(54) Flansch für aus Teilen zusammensetzbare Abschirmgehäuse.

(57) Bei einem Flansch für aus Teilen zusammensetzbaren Gehäuse für elektronische Geräte wird die Abschirmwirkung dadurch wesentlich erhöht, daß die Flanschen, welche die Teilfugen bilden aus zwei Teilfugen gebildet sind, deren erste in der Teilungsbene und deren zweite in einem vorzugsweise dazu senkrechten Winkel angeordnet ist, sodaß die Abschirmwirkung der eines geschlossenen Gehäuses gleich ist.

EP 0 025 426 A1

./...

FIG. 2

## Flansch für aus Teilen zusammensetzbare Abschirmgehäuse

Gegenstand der Erfindung ist ein Flansch für aus Teilen zusammensetzbare Abschirmgehäuse. Zusammensetzbare Abschirmgehäuse werden verwendet, um elektronische Geräte zu umgeben, die entweder elektromagnetische Schwingungen erzeugen um den Austritt dieser Schwingungen in die Umgebung zu verhindern, oder diese Geräte vor der Einwirkung solcher aus der Umgebung kommender elektromagnetischen Schwingungen zu schützen. Zum Ein- oder Ausbau der Geräte müssen die Gehäuse teilbar sein und sind daher aus Teilen gebildet, die parallel zur Teilungsfläche, vorzugsweise einer Teilungsebene verlaufende Flansche aufweisen. Mittels dieser zueinander passenden Flansche, die durch mechanische Mittel aneinander gepreßt werden, kann nach Einbringen des elektronischen Gerätes das Gehäuse geschlossen werden. Dabei wird versucht, durch Zwischenlage von Mehrfach-Kontaktfederstreifen den undefinierbaren Flächenkontakt zu verbessern und die für die Schirmwirkung maßgebliche sogenannte Fugenbreite zu verringern. Die Fugentiefe, die der Breite der Flansche bzw. gegebenenfalls der Breite des schmäleren Flansches entspricht, ist ebenfalls für die Schirmwirkung maßgeblich, kann aber aus praktischen Gründen nicht allzugroß ausgeführt werden, um nicht den für das einzubauende Gerät verfügbaren Querschnitt allzusehr einzuengen. Daher ergab es sich, daß im Fugenbereich stets eine verringerte Schirmwirkung festzustellen war.

Die Erfindung besteht darin, daß der Flansch aus zwei Teilflächen gebildet ist, deren erste in der Teilungsebene und deren zweite im Winkel vorzugsweise senkrecht zur Teilungsebene angeordnet ist.

Der Vorteil der erfindungsgemäßen Ausbildung liegt darin, daß der Flansch beliebig verlängert werden kann ohne den freien Innenraum mehr zu beschränken, sodaß die Schirmwirkung der eines geschlossenen Gehäuses praktisch gleichwertig gemacht werden kann.

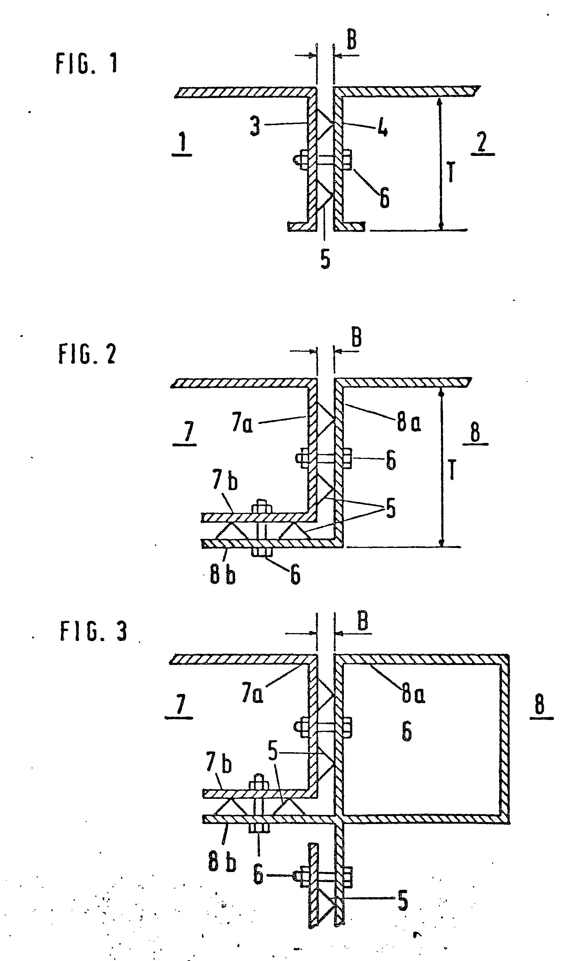

Anhand der Fig. 1 - 3 die in Schnittbildern, ausgehend von einer dem Stand der Technik entsprechenden Ausführungsform die erfindungsgemäße Weiterbildung von Flanschen zeigen, soll die Erfindung kurz erläutert werden.

Fig. 1 zeigt eine Teilfuge mit den bisher verwendeten Flanschen. Die Gehäuseteile 1 und 2 weisen in einer Ebene parallel zueinander angeordnete Flansche 3 und 4 auf, zwischen denen zur Verbesserung des Kontaktes federnde Kontaktstreifen 5 beigelegt sind. Die Gehäuseteile 1 und 2 werden an den Flanschen mittels Schrauben 6 zusammengepreßt. Die Fuge weist eine Fugenbreite B und eine Fubentiefe T auf.

Fig. 2 zeigt eine Teilfuge, die aus erfindungsgemäß ausgestalteten Flanschen 7 und 8 gebildet ist, wobei jeder Flansch aus einer in der Teilungsebene angeordneten ersten Teilfläche 7a bzw. 8a sowie einer senkrecht dazu angeordneten zweiten Teilfläche 7b bzw. 8b besteht. Die federnden Kontaktstreifen 5 können zwischen allen parallelen Teilflächen angeordnet werden.

Fig. 3 zeigt mit den gleichen Bezugszeichen die Ausbildung eines sogenannten Eckwinkels, der zur Versteifung des Gehäuses dient, mittels erfindungsgemäß ausgestalteter Flanschelemente.

Aus allen Figuren ist deutlich zu ersehen, daß trotz beliebiger - sinnvoller - Verlängerung der Fuge das Maß T nicht überschritten werden muß.

Patentanspruch:

Flansch für aus Teilen zusammensetzbare Abschirmgehäuse,
dadurch gekennzeichnet,
daß der Flansch aus zwei Teilflächen gebildet ist, deren erste in der
Teilungsebene und deren zweite im Winkel, vorzugsweise senkrecht zur
Teilungsebene angeordnet ist.

FIG. 1

FIG. 2

FIG. 3

## RAPPORT DE RECHERCHE EUROPEENNE

Office européen des brevets

EP 80 89 0093

| DOCUMENTS CONSIDERES COMME PERTINENTS | | | CLASSEMENT DE LA DEMANDE (Int. Cl. ³) |
|---|---|---|---|
| Catégorie | Citation du document avec indication, en cas de besoin, des parties pertinentes | Revendication concernée | |
| X | US - A - 3 013 103 (EUGENE D., PETTLER ALEXANDER M. INTRATOR)<br><br>* Spalte 1, Zeilen 66-69; Spalte 2, Zeilen 1-2; Spalte 2, Zeilen 7-20; Abbildung 4 *<br><br>-- | 1 | H 05 K 9/00 |
| X | US - A - 3 247 312 (SAMUEL P. ALESSI)<br><br>* Spalte 1, Zeilen 56-59; Spalte 2, Zeilen 37-44; Abbildung 2 *<br><br>-- | 1 | |
| X | GB - A - 909 009 (RADYNE LTD.)<br><br>* Seite 2, Zeilen 1-22; Zeilen 80-93; Abbildungen 1,3,4 *<br><br>-- | 1 | DOMAINES TECHNIQUES RECHERCHES (Int. Cl. ³)<br><br>H 05 K 9/00 |
| A | FR - A - 2 078 686 (SIEMENS A.G.)<br><br>* Seite 1, Zeilen 1-20; Seite 3, Zeilen 13-19; Abbildung 1 *<br><br>& DE - A - 2 009 119<br><br>---- | 1 | |

**CATEGORIE DES DOCUMENTS CITES**

X: particulièrement pertinent

A: arrière-plan technologique

O: divulgation non-écrite

P: document intercalaire

T: théorie ou principe à la base de l'invention

E: demande faisant interférence

D: document cité dans la demande

L: document cité pour d'autres raisons

&: membre de la même famille, document correspondant

X Le présent rapport de recherche a été établi pour toutes les revendications

| Lieu de la recherche | Date d'achèvement de la recherche | Examinateur |
|---|---|---|
| Den Haag | 20-11-1980 | MIOT |

OEB Form 1503.1 06.78